# EUROPEAN PATENT SPECIFICATION

(11) **EP 2 090 674 B1**
(45) Date of publication and mention of the grant of the patent: **13.03.2013**
(21) Application number: 08100933.4
(22) Date of filing: 25.01.2008
(51) Int. Cl.: C23C 14/56, C23C 16/54, C23C 16/52, C23C 14/54

(54) **Vacuum coating installation and method of producing a coating layer on a substrate.**
Vakuumbeschichtungsinstallation und Verfahren zur Erzeugung einer Beschichtung auf einem Substrat.
Installation de dépõt sous vide et procédé pour produire une couche de revêtement sur un substrat.

(43) Date of publication of application: 19.08.2009
(73) Proprietor: Applied Materials, Inc., Santa Clara, CA 95054 (US)
(72) Inventor: Lotz, Hans-Georg, 63584 Gründau-Rothenbergen (DE); Sauer, Peter, 36381 Schlüchtern (DE)
(74) Representative: Neuburger, Benedikt Maria

(56) References cited:
- JP-A- 10 060 642
- US-A- 4 627 989
- US-B1- 6 642 066
- FUZHONG YU: "IN-SITU MONITORING OF EPITAXIAL FILM THICKNESS BY IEMI" IEEE TRANSACTIONS ON SEMICONDUCTOR MANUFACTURING, IEEE SERVICE CENTER, PISCATAWAY, NJ, US, vol. 5, no. 1, 1 February 1992 (1992-02-01), pages 34-40, XP000290616 ISSN: 0894-6507

## Description

### TECHNICAL FIELD

The invention relates to a vacuum coating installation comprising a coating chamber and coating tools for depositing a coating layer on a substrate. Furthermore, the invention refers to a method of producing a coating film on a substrate, comprising the steps of: a) providing a substrate in a coating chamber; b) depositing a coating film having a physical characteristic, particularly a thickness, on a surface of said substrate in said coating chamber; and c) determining the physical characteristic, particularly the thickness, of said coating film deposited on said surface of said substrate. Moreover, the invention relates to a method of measuring the thickness of a silicon layer deposited on a substrate.

### STATE OF THE ART

In a plurality of technical applications thin layers or stacks of thin layers are required. It is obvious that after the deposition of a layer or a stack of layers particular physical characteristics of the layer have to be measured in order to ensure an acceptable and constant quality of the layer system. One of the parameters to be measured is the thickness of a layer deposited on a substrate. Due to the fact that the thickness of a layer affects a number of physical properties of the layer system the measurement of the thickness of the layer is particularly important.

The selection of a suitable measurement and detection systems used for determining a layer thickness depends on the material of the coating film and the properties of the substrate as well as the arrangement of layers in the layer system. In fact a number of measurement and detection methods are known. For example, the thickness of a layer may be determined by measuring reflection and/or transmission effects, e.g. the interference of a first wave reflected from the surface of a film deposited on a substrate and a second wave reflected from the surface of the substrate. The methods include single wavelength measurements and spectral wavelength range measurements, e.g. in a visible and ultraviolet (UV) range.

However, for determining the thickness of a layer of particular materials the methods usually employed are not suitable. For example, the measurement of the thickness of a silicon layer produced in a vacuum coating installation is difficult. Furthermore, for determining the thickness of silicon layers used in solar applications the results of optical measurements are often deteriorated due to the fact that the surfaces of these layers are structured/ patterned. The structured/ patterned surfaces cause scattering of light and spurious interference effects. Another problem is the relatively high absorption of light in silicon layers.

Furthermore, a number of measurement methods may only be carried out after the deposition of a film and after removal of the substrate from a coating chamber in a separate process. Therefore, it is not possible to react immediately when the thickness of the layer diverges from a nominal range.

### OBJECT OF THE INVENTION

It is an object of the present invention to provide a vacuum coating installation and a method of producing a coating layer on a substrate allowing a reliable measurement of a layer characteristic, particularly the thickness of the layer, in the production process of the layer even if the surface of the layer is structured. Furthermore, another object is that the system and the method allow a fast reaction in the coating process when the thickness of the layer diverges from a nominal range.

Document JP 10060642A discloses a vacuum chamber for depositing organic material on a substrate by means of an evaporation process. An IR beam is coupled into the process chamber for determining the thickness of the layer.

Document US 6,642,066 and the article by Fuzhong Yu: "In-situ monitoring of epitaxial film thickness by IEMI", IEEE Transaction on Semiconductor Manufacturing, IEEE Service Center, Piscataway, NJ, US, vol. 5, no. 1 (01.02.1992), p. 34-40, refer to a coating system using an ellipsometric measurement of parameters and an Infrared Emission Michelson Interferometer (IEMI) measurement, respectively, for determining the thickness of a material layer deposited on a substrate.

Document 4,627,989 discloses a method and system for vacuum-evaporative film deposition. There is a film thickness sensor and a control loop. The film-thickness distribution may be corrected at high speed.

Document US 6,096,133 refers to FT-IR measurement for controlling the reaction parameters during the film forming process in a CVD apparatus.

### TECHNICAL SOLUTION

The objects are achieved by providing a vacuum coating installation according to claim 1, and a method of producing a coating layer on a substrate according to claim.

A vacuum coating installation for coating a substrate in a continuous coating process according to the invention comprises: a coating chamber; and coating tools for depositing a coating layer on the a substrate. Furthermore, the vacuum coating installation comprises a determining means for determining a physical characteristic, particularly a thickness, of the coating film deposited on the substrate. The determining means is comprised in the vacuum coating installation. Furthermore, the vacuum coating installation comprises a feedback control unit for controlling one or a plurality of parameters of said vacuum coating installation responsive to said physical characteristic determined by said determining means for controlling the thickness of a coating film deposited in said coating section. The determining means comprises an infrared (IR) spectroscopic measurement means arranged downstream said coating section for measuring said physical characteristic, particularly said thickness, of said coating film deposited on said substrate. The infrared (IR) spectroscopic measurement means comprises an IR emission source for emitting IR radiation to be reflected from said substrate and/or said coating film deposited on said substrate. The spectral wavelength range for measurement is between 1000 nm and 1700 nm.

Whereas in conventional systems the thickness of a layer is determined in a separate process, i. e. ex-situ, in the present invention the determining means is part of the coating installation, thus providing the possibility of an in-situ measurement of the thickness of a layer.

The invention refers especially to the measurement of the thickness of a silicon layer deposited on a metal substrate or a substrate, e.g. a plastic substrate, coated with a metal layer in a strip coating installation. Silicon layers are required in a lot of technical applications, e.g. in solar cell applications and may have a patterned/structured surface. However, generally other properties may be determined, e.g. properties of layer stacks or of silicon layers being deposited on top of intermediate layers arranged between the silicon layer and the substrate.

The coating tools are coating tools for depositing e.g. a silicon coating film/ silicon layer on a substrate. The term "silicon coating film" may comprise any layer that includes at least a fraction of silicon. The coating process is carried out in a vacuum atmosphere. Any suitable coating process, e.g. an evaporation coating process, a CVD coating process, a PVD coating process, a sputter coating process, a plasma-supported coating process, etc. may be used.

For implementing the in-situ measurement of the thickness of the silicon layer, a suitable measuring device is provided which allows the measurement of the physical property, particularly the thickness of the layer, in a vacuum atmosphere. Determining a physical characteristic includes determining a physical property (e.g. the thickness) or an alteration of the physical property. Besides, the measuring device allows an exact and reliable measurement of the characteristic even if a pattern or structure is formed on the surface of the layer. Furthermore, a fast measuring method is provided which allows a fast reaction when the determined characteristic deviates from a nominal value (range). The parameters of the coating process may be controlled to compensate for the deviation.

The thickness of a coating film may be measured in the vacuum coating chamber in a vacuum atmosphere immediately after the coating film has been deposited on a first substrate or a first section of an elongated substrate. At the same time the coating process may continue for depositing a coating film on a second substrate or on a second section of the elongated substrate. When using the inventive system and method, particularly in a strip coating device, including an in-situ measurement, modifications of the characteristics (e.g. the thickness of a silicon layer deposited on a substrate) may already be determined in the vacuum coating chamber allowing a prompt reaction. On the other hand, in an ex-situ measurement, i.e. in a measurement outside the coating chamber, defects and bad properties of the coating film may be determined, but not corrected promptly.

It is preferred that the measurement means is arranged within the coating chamber for providing an in-situ measurement of the characteristic of the coating film deposited on the substrate. An in-situ measurement means that the measurement takes place substantially in the same place as the coating process, i.e. in the vacuum coating chamber.

An in-situ measurement in a vacuum atmosphere requires a measurement device which functions under vacuum conditions. In this way an on-line measurement of the thickness of the silicon layer may be implemented providing a short reaction time when the coating parameters and thus the physical characteristic diverge from a desired nominal value range.

Therefore, the measurement means comprises an infrared (IR) spectroscopic measurement means. An IR spectroscopic measurement means is an optical measurement means allowing a contactless, non-destructive measurement of the coating film. Besides allowing an in-situ measurement the infrared (IR) spectroscopic measurement means shows a considerable effect when the physical properties of the layer change. For example, in e typical solar application silicon layers of a thickness of more than 200 nm generate reflexion maxima in the IR spectral range which may be, due to their spectral position, easily evaluated. The refraction index is approximately 3.5.

The IR emission source may emit radiation having one or a plurality of discrete wavelengths or a spectral range of IR radiation.

The quantity of a decrease and an increase of the thickness of the coating film, respectively, may be determined from the modification(s) in the IR reflection spectrum.

In a preferred embodiment of the invention the vacuum coating installation is a vacuum strip coating installation.

An in-situ measurement according to the invention is particularly suitable for being used in a continuous coating process. In vacuum strip (band/ tab) coating installations a first pulley carries a flexible substrate (e.g. made of metal and/or Al/Mo and/or a substrate, e.g. a plastic substrate, coated with a metal/Al/Mo layer) wound up thereon. The first pulley continuously provides a strip of substrate material, and a second pulley (take-up pulley) receives and winds up the coated strip of substrate material. Between the first pulley and the second pulley coating tools are arranged to deposit a silicon layer on the substrate passing the coating tool, e.g. in an evaporation coating process, a CVD coating process, a PVD coating process, a sputter coating process, a plasma-supported coating process, etc.

The measurement means, e.g. a sensor device, is arranged between a coating section, wherein the silicon layer is deposited on a portion of the substrate strip, and the second pulley. The sensor carries out the measurement for determining the thickness of the silicon layer. The in-situ measurement may be carried out online while the coated strip passes the sensor device continuously. This allows for a continuous control, e.g. a feedback control, of the thickness of the silicon layer and the parameters of the coating process, especially the parameters having an effect on the thickness of the layer.

In a preferred embodiment of the invention the vacuum coating installation comprises a control unit for controlling one or a plurality of the parameters of the coating installation responsive to the physical characteristic determined by the determining means. The control unit may comprise a feedback control using the thickness of the coating layer as a control parameter in order to control the process parameters influencing the thickness of the coating film during the coating process. Therefore, the layer properties may be monitored in-situ and online during the manufacturing process using one or a plurality of sensors arranged at suitable positions in the coating installation. A change in the amplitude or the shape of the reflected peak may indicate a change of a characteristic and particularly of the thickness of the silicon layer.

The object is also achieved by providing a method of producing a coating film on a substrate, comprising the steps of: a) providing a continuously moving substrate in a coating chamber; b) depositing a coating film having a physical characteristic, particularly a thickness, on a first section of the surface of the substrate in a coating section of the coating chamber while the first section of the surface of said substrate passes the coating section; c) determining the physical characteristic, particularly the thickness, of the coating film deposited on the surface of the substrate downstream the coating section in the coating chamber; and d) feedback controlling one or a plurality of parameters of said coating process responsive to said physical characteristic for controlling the thickness of the coating film deposited on a second section of said surface of said substrate in said coating section of said coating chamber while said second section of said surface of said substrate passes said coating section. The method step c) of determining the physical characteristic includes a step of using an infrared (IR) spectroscopic measuring method, wherein IR radiation is reflected from said substrate and/or said coating film deposited on said substrate; and the spectral wavelength range for measurement is between 1000 nm and 1700 nm.

The method step b) of depositing a coating film comprises using a coating process, e.g. a PVD-process, a CVD process, a sputter process, an evaporation process, a plasma enhanced process, etc. In a continuous coating process a first section of the substrate is coated while a second section of the substrate which has already been provided with a coating film is subject to the method according to c).

The method step c) of measuring the physical characteristic includes an infrared (IR) spectroscopic measuring method. This optical measurement method is a contactless and thus a non-destructive method.

The infrared (IR) spectroscopic measuring method includes measuring an IR radiation reflection spectrum reflected from the substrate and/or the coating film deposited on the surface of the substrate. An IR reflection spectroscopic method is suitable for measuring properties and/or the thickness of a silicon layer deposited on a substrate in a vacuum atmosphere, i.e. in-situ. The incoming radiation may have one or a plurality of discrete wavelengths or be a continuous wavelength spectrum of a spectral range.

Particularly, the intensity of the IR radiation reflection spectrum is measured as a function of the wavelength of the radiation. An example may be a measurement of the intensity as a function of the wavelength of the reflected IR radiation. It may also be possible to vary the wavelength of the incoming radiation during a measurement cycle. A spectroscopic method may be used for determining the IR reflection spectrum of a silicon layer (e.g. α-Si, n-Si) deposited on a metal substrate or on a substrate, e.g. a plastic substrate, coated with a metal layer. The spectral wavelength range may be above 1000 nm up to approximately 1700 nm. An advantage of a measurement of a reflection spectrum of a silicon layer deposited on a metal foil in the IR wavelength range is that silicon is transparent for electromagnetic radiation above 1000 nm. Therefore, thin layers may be measured as well as relatively thick layers (compared with the wavelength of the radiation). Furthermore, the influence of structures and textures used in solar technology are considerably reduced. There is no scattered light which would considerably disturb the optical measurement.

An expected spectrum corresponding to a particular thickness may be obtained by computation or by measuring a spectrum of a standard. During the measurement of the thickness the IR radiation spectrum is compared with these spectra to determine deviations from the standard.

In a preferred embodiment the method step b) includes depositing a coating film on a surface of the substrate using a vacuum strip coating process.

In a preferred embodiment of the invention the method step b) includes depositing a silicon layer on the surface of the substrate. The substrate may be a metal substrate and/or a metal substrate coated with an aluminium (Al) or molybdenum (Mo) layer.

Protection is claimed for the described method and device features in any combination of these features.

### BRIEF DESCRIPTION OF THE DRAWINGS

Further features and advantages of the present invention will be apparent from the following description of preferred embodiments and the attached drawings. The drawings show:
Fig. 1 a schematic view of a vacuum strip coating system according to the invention; and
Fig. 2 a schematic view of a thickness determining means according to the present invention.

### DESCRIPTION OF A PREFERRED EMBODIMENT

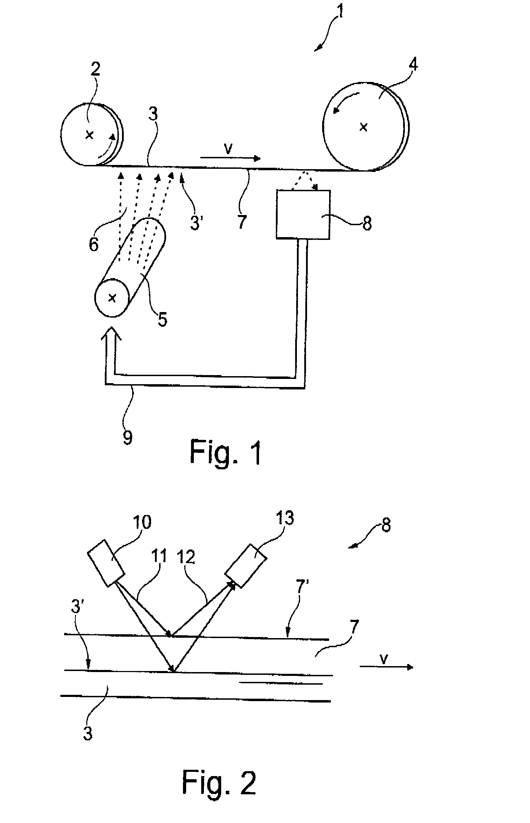

Figure 1 is a schematic view of a strip coating system 1 according to the present invention.

The strip coating system 1 comprises a first pulley 2 carrying an elongated flexible metal or Al/Mo coated metal substrate 3 wound up on the first pulley 2. Furthermore, the strip coating system 1 has a second pulley 4 (take-up pulley) for taking up the coated substrate 3.

The coating process carried out in the strip coating system 1 is a continuous coating process. During the coating process the first pulley 2 and the second pulley 4 are rotated to move the substrate 3 continuously past a coating tool 5 to deposit the coating particles 6 on a surface 3' of the substrate 3.

After having passed the coating section with a speed v the substrate carrying a coating film 7 on the surface 3' thereof passes an IR spectroscopic measurement device 8 for measuring an IR reflexion spectrum of the coating film 7 for determining the thickness of the coating film 7.

The coating tool 5 may be any suitable coating tool for depositing a silicon (or any layer having similar properties with respect to the possibility of an IR spectroscopic measurement) on a substrate, e.g. a sputter coating tool, a CVD coating tool, a PVD coating tool, an evaporation tool, a tool for a plasma enhanced process, etc.

An arrow 9 in Figure 1 indicates a feedback control between the IR measurement device 8 and the coating tool 5. The feedback control 9 controls one or a plurality of process parameters of the coating tool 5 responsive to the measurement of the thickness of the coating film 7 detected by the measurement tool 8. Thus, an in-situ on-line measurement of the thickness of the coating film 7 may be implemented.

The described components 2, 4, 5, and 8, as well as the substrate 3, the coating particles 6 forming the silicon layer 7 on the substrate 3, are arranged and accommodated within a vacuum coating chamber (not illustrated), particularly within the vacuum coating chamber of a vacuum strip coating installation (not illustrated).

Figure 2 illustrates a particular embodiment of the IR measurement arrangement 8 of Figure 1.

The IR measurement device 8 comprises an IR radiation emitter 10 to emit a single wavelength or a spectral range of IR radiation 11. The bundle 11 of IR radiation may have one or a plurality of discrete wavelengths or be a bundle of a spectral wavelength range.

The emitted radiation 11 is reflected on boundary layers, e.g. on the surface 7' of the silicon coating film 7 and/or on the front surface 3' of the substrate 3. The reflected beam 12 is detected by an IR detector 13. The IR measurement device 13 may measure an IR reflection intensity spectrum, e.g. as a function of one or a plurality of wavelengths of the reflected IR radiation, as a function of an angle of incidence of the incoming beam, etc.

During a measurement the IR detector 13 may be arranged in a particular angle relative to the surface 3' of the substrate 3. The angle may be varied during a measurement or between two measurements. The reflected IR radiation 12 is detected at a particular wavelength and/or as an intensity spectrum of a number of different wavelengths.

This method of determining the thickness of a silicon layer 7 is particularly suitable for measuring online in a vacuum atmosphere delivering good results even if the surface 7' of the silicon layer 7 is structured/patterned.

## Claims

1. A vacuum coating installation (1) for coating a substrate in a continuous coating process comprising:
a coating chamber;
coating tools (5) for depositing a coating layer (7) on said substrate (3) in a coating section of said coating chamber;
a determining means (8) for determining a physical characteristic, particularly a thickness, of said coating layer (7) deposited on said substrate (3); and
a feedback control unit for controlling one or a plurality of parameters of said vacuum coating installation responsive to said physical characteristic determined by said determining means (8) for controlling the thickness of a coating film deposited in said coating section;
**characterized in that**
said determining means (8) comprises an infrared (IR) spectroscopic measurement means (10, 13) arranged downstream said coating section for measuring said physical characteristic, particularly said thickness, of said coating film (7) deposited on said substrate (3);
said infrared (IR) spectroscopic measurement means (10, 13) comprises an IR emission source (10) for emitting IR radiation to be reflected from said substrate (3) and/or said coating film (7) deposited on said substrate (3); and
the spectral wavelength range for measurement is between 1000 nm and 1700 nm.

2. The vacuum coating installation (1) according to claim 1,
**characterized in that**
said measurement means (10, 13) is arranged within said coating chamber for providing an in-situ measurement of the characteristic of said coating film (7) deposited on said substrate (3).

3. The vacuum coating installation (1) according to claim 2,
**characterized in that**
said infrared (IR) spectroscopic measurement means (10, 13) comprises an IR detector (13) for detecting IR radiation reflected from said substrate (3) and/or said coating film (7) deposited on said substrate (3) as a function of the wavelength of the IR radiation.

4. The vacuum coating installation (1) according to any of the previous claims, **characterized in that**
said vacuum coating installation (1) is a vacuum strip coating installation.

5. The vacuum coating installation (1) according to any of the previous claims, **characterized in that**
said vacuum coating installation (1) comprises a control unit (9) for controlling one or a plurality of parameters of said vacuum coating installation responsive to said physical characteristic determined by said determining means.

6. A coating method of producing a coating film (7) on a substrate (3), comprising the steps of:
a) providing a continuously moving substrate (3) in a coating chamber;
b) depositing a coating film (7) having a physical characteristic, particularly a thickness, on a first section of the surface (3') of said substrate (3) in a coating section of said coating chamber while said first section of the surface (3') of said substrate (3) passes said coating section;
c) determining said physical characteristic, particularly said thickness, of said coating film (7) deposited on said first section of said surface (3') of said substrate (3) downstream said coating section in said coating chamber and
d) feedback controlling one or a plurality of parameters of said coating process responsive to said physical characteristic for controlling the thickness of the coating film deposited on a second section of said surface (3') of said substrate (3) in said coating section of said coating chamber while said second section of said surface (3') of said substrate (3) passes said coating section,
**characterized in that**
step c) includes using an infrared (IR) spectroscopic measuring method, wherein IR radiation is reflected from said substrate (3) and/or said coating film (7) deposited on said substrate (3); and
the spectral wavelength range for measurement is between 1000 nm and 1700 nm.

7. The method according to claim 6,
**characterized in that**
said method step b) includes depositing said coating film (7) on said surface (3') of said substrate (3) using a vacuum strip coating process.

8. The method according to any of the previous claims 6 or 7,
**characterized in that**
said method step b) includes depositing a silicon layer on said surface (3') of said substrate (3).

## Patentansprüche

1. Vakuumbeschichtungsanlage (1) zum Beschichten eines Substrats in einem kontinuierlichen Beschichtungsprozess, Folgendes umfassend:
eine Beschichtungskammer;
Beschichtungswerkzeuge (5) zum Abscheiden einer Überzugsschicht (7) auf dem Substrat (3) in einem Beschichtungsabschnitt der Beschichtungskammer;
eine Bestimmungseinrichtung (8) zum Bestimmen eines physikalischen Merkmals, insbesondere einer Dicke der auf dem Substrat (3) abgeschiedenen Überzugsschicht (7); und
eine Rückführregelungseinheit zum Regeln eines Parameters oder
mehrerer Parameter der Vakuumbeschichtungsanlage im Ansprechen auf das durch die Bestimmungseinheit (8) bestimmte physikalische Merkmal,
um die Dicke einer in dem Beschichtungsabschnitt abgeschiedenen Überzugsschicht zu regeln;
**dadurch gekennzeichnet, dass**
die Bestimmungseinheit (8) eine Infrarot-(IR)-Spektroskopiemesseinrichtung (10, 13) umfasst, die nach dem Beschichtungsabschnitt angeordnet ist, um das physikalische Merkmal, insbesondere die Dicke der auf dem Substrat (3) abgeschiedenen Überzugsschicht (7) zu messen;
wobei die Infrarot-(IR)-Spektroskopiemesseinrichtung (10, 13) eine IR-Abstrahlquelle (10) umfasst, um vom Substrat (3) und/oder von der auf dem Substrat (3) abgeschiedenen Überzugsschicht (7) zu reflektierende IR-Strahlung abzustrahlen; und
der spektrale Wellenlängenbereich zur Messung zwischen 1000 nm und 1700 nm beträgt.

2. Vakuumbeschichtungsanlage (1) nach Anspruch 1,
**dadurch gekennzeichnet, dass**
die Messeinrichtung (10, 13) in der Beschichtungskammer angeordnet ist, um eine in situ-Messung des Merkmals der auf dem Substrat (3) abgeschiedenen Überzugsschicht (7) bereitzustellen.

3. Vakuumbeschichtungsanlage (1) nach Anspruch 2,
**dadurch gekennzeichnet, dass**
die Infrarot-(IR)-Spektroskopiemesseinrichtung (10, 13) einen IR-Detektor (13) umfasst, um vom Substrat (3) und/oder von der auf dem Substrat (3) abgeschiedenen Überzugsschicht (7) reflektierte IR-Strahlung in Abhängigkeit von der Wellenlänge der IR-Strahlung zu erfassen.

4. Vakuumbeschichtungsanlage (1) nach einem der vorhergehenden Ansprüche,
**dadurch gekennzeichnet, dass**
es sich bei der Vakuumbeschichtungsanlage (1) um eine Vakuumbandbeschichtungsanlage handelt.

5. Vakuumbeschichtungsanlage (1) nach einem der vorhergehenden Ansprüche,
**dadurch gekennzeichnet, dass**
die Vakuumbeschichtungsanlage (1) eine Regeleinheit (9) zum Regeln eines Parameters oder mehrerer Parameter der Vakuumbeschichtungsanlage im Ansprechen auf das durch die Bestimmungseinheit bestimmte Merkmal umfasst.

6. Beschichtungsverfahren zum Herstellen einer Überzugsschicht (7) auf einem Substrat (3), folgende Schritte umfassend:
a) Bereitstellen eines sich kontinuierlich bewegenden Substrats (3) in einer Beschichtungskammer;
b) Abscheiden einer Überzugsschicht (7) mit einem physikalischen Merkmal, insbesondere einer Dicke, auf einem ersten Abschnitt der Oberfläche (3') des Substrats (3) in einem Beschichtungsabschnitt der Beschichtungskammer, während der erste Abschnitt der Oberfläche (3') des Substrats (3) den Beschichtungsabschnitt durchläuft;
c) Bestimmen des physikalischen Merkmals, insbesondere der Dicke der auf dem ersten Abschnitt der Oberfläche (3') des Substrats (3) abgeschiedenen Überzugsschicht (7) nach dem Beschichtungsabschnitt in der Beschichtungskammer, und
d) Rückführregeln eines Parameters oder mehrerer Parameter des Beschichtungsprozesses im Ansprechen auf das physikalische Merkmal, um die Dicke der auf einem zweiten Abschnitt der Oberfläche (3') des Substrats (3) im Beschichtungsabschnitt der Beschichtungskammer abgeschiedenen Überzugsschicht zu regeln, während der zweite Abschnitt der Oberfläche (3') des Substrats (3) den Beschichtungsabschnitt durchläuft,
**dadurch gekennzeichnet, dass**
Schritt c) umfasst, ein Infrarot-(IR)-Spektroskopiemessverfahren einzusetzen, wobei IR-Strahlung vom Substrat (3) und/oder von der auf dem Substrat (3) abgeschiedenen Überzugsschicht (7) reflektiert wird; und
der spektrale Wellenlängenbereich zur Messung zwischen 1000 nm und 1700 nm beträgt.

7. Verfahren nach Anspruch 6,
**dadurch gekennzeichnet, dass**
der Verfahrensschritt b) umfasst, die Überzugsschicht (7) auf der Oberfläche (3') des Substrats (3) unter Verwendung eines Vakuumbandbeschichtungsprozesses abzuscheiden.

8. Verfahren nach einem der vorhergehende Ansprüche 6 oder 7,
**dadurch gekennzeichnet, dass**
der Verfahrensschritt b) umfasst, eine Siliciumschicht auf der Oberfläche (3') des Substrats (3) abzuscheiden.

## Revendications

1. Installation de recouvrement sous vide (1) destinée à recouvrir un substrat dans un processus de recouvrement continu, comprenant :
une chambre de recouvrement ;
des outils de recouvrement (5) destinés à déposer une couche de recouvrement (7) sur ledit substrat (3) dans une section de recouvrement de ladite chambre de recouvrement ;
un moyen de détermination (8) destiné à déterminer une caractéristique physique, en particulier une épaisseur, de ladite couche de recouvrement (7) déposée sur ledit substrat (3) ; et
une unité de régulation à rétroaction destinée à réguler un paramètre ou
une pluralité de paramètres de ladite installation de recouvrement sous vide en réponse à ladite caractéristique physique déterminée par ledit moyen de détermination (8) en vue de réguler l'épaisseur d'un film de recouvrement déposé dans ladite section de recouvrement ;
**caractérisée en ce que**
ledit moyen de détermination (8) comprend un moyen de mesure spectroscopique (10, 13) à infrarouge (IR) disposé en aval de ladite section de recouvrement pour mesurer ladite caractéristique physique, en particulier ladite épaisseur, dudit film de recouvrement (7) déposé sur ledit substrat (3) ;
ledit moyen de mesure spectroscopique (10, 13) à infrarouge (IR) comprend une source d'émission IR (10) destinée à émettre un rayonnement IR destiné à être réfléchi par ledit substrat (3) et/ou ledit film de recouvrement (7) déposé sur ledit substrat (3) ; et
la plage de longueur d'onde spectrale pour la mesure est comprise entre 1 000 nm et 1 700 nm.

2. L'installation de recouvrement sous vide (1) selon la revendication 1, **caractérisée en ce que**
ledit moyen de mesure (10, 13) est disposé à l'intérieur de ladite chambre de recouvrement pour fournir une mesure in-situ de la caractéristique dudit film de recouvrement (7) déposé sur ledit substrat (3).

3. L'installation de recouvrement sous vide (1) selon la revendication 2, **caractérisée en ce que**
ledit moyen de mesure spectroscopique (10, 13) à infrarouge (IR) comprend un détecteur IR (13) destiné à détecter un rayonnement IR réfléchi par ledit substrat (3) et/ou ledit film de recouvrement (7) déposé sur ledit substrat (3) en fonction de la longueur d'onde du rayonnement IR.

4. L'installation de recouvrement sous vide (1) selon l'une quelconque des revendications précédentes,
**caractérisée en ce que**
ladite installation de recouvrement sous vide (1) est une installation de recouvrement par bande sous vide.

5. L'installation de recouvrement sous vide (1) selon l'une quelconque des revendications précédentes,
**caractérisée en ce que**
ladite installation de recouvrement sous vide (1) comprend une unité de régulation (9) destinée à réguler un paramètre ou une pluralité de paramètres de ladite installation de recouvrement sous vide en réponse à ladite caractéristique physique déterminée par ledit moyen de détermination.

6. Procédé de recouvrement permettant de réaliser un film de recouvrement (7) sur un substrat (3), comprenant les étapes consistant à :
a) mettre à disposition un substrat (3) en déplacement continu dans une chambre de recouvrement ;
b) déposer un film de recouvrement (7) ayant une caractéristique physique, en particulier une épaisseur, sur une première section de la surface (3') dudit substrat (3) dans une section de recouvrement de ladite chambre de recouvrement pendant que ladite première section de la surface (3') dudit substrat (3) passe par ladite section de recouvrement ;
c) déterminer ladite caractéristique physique, en particulier ladite épaisseur, dudit film de recouvrement (7) déposé sur ladite première section de ladite surface (3') dudit substrat (3) en aval de ladite section de recouvrement dans ladite chambre de recouvrement et
d) réguler avec rétroaction un paramètre ou une pluralité de paramètres dudit processus de recouvrement en réponse à ladite caractéristique physique pour réguler l'épaisseur du film de recouvrement déposé sur une deuxième section de ladite surface (3') dudit substrat (3) dans ladite section de recouvrement de ladite chambre de recouvrement pendant que ladite deuxième section de ladite surface (3') dudit substrat (3) passe par ladite section de recouvrement ;
**caractérisé en ce que**
l'étape c) inclut l'utilisation d'un procédé de mesure spectroscopique à infrarouge (IR), dans lequel un rayonnement IR est réfléchi par ledit substrat (3) et/ou ledit film de recouvrement (7) déposé sur ledit substrat (3) ; et
la plage de longueur d'onde spectrale pour la mesure est comprise entre 1 000 nm et 1 700 nm.

7. Le procédé selon la revendication 6,
**caractérisé en ce que**
ladite étape de procédé b) inclut le dépôt dudit film de recouvrement (7) sur ladite surface (3') dudit substrat (3) moyennant un processus de recouvrement par bande sous vide.

8. Le procédé selon l'une quelconque des revendications précédentes 6 ou 7, **caractérisé en ce que**
ladite étape de procédé b) inclut le dépôt d'une couche de silicium sur ladite surface (3') dudit substrat (3).
